Europäisches Patentamt

European Patent Office

Office européen des brevets

(11) Publication number : **0 439 000 B1**

(12) **EUROPEAN PATENT SPECIFICATION**

(45) Date of publication of patent specification :
14.09.94 Bulletin 94/37

(51) Int. Cl.⁵ : **H02N 13/00, H01L 21/00**

(21) Application number : **91100003.2**

(22) Date of filing : **02.01.91**

(54) **Electrostatic clamp and method.**

(30) Priority : **25.01.90 US 470288**

(43) Date of publication of application :
**31.07.91 Bulletin 91/31**

(45) Publication of the grant of the patent :
**14.09.94 Bulletin 94/37**

(84) Designated Contracting States :
**BE DE ES FR GB IT NL**

(56) References cited :
**EP-A- 0 171 011**
**WO-A-79/00510**
**GB-A- 1 443 215**
**US-A- 4 671 204**

(73) Proprietor : **APPLIED MATERIALS INC.**
**PO Box 58039**
**Santa Clara California 95052 (US)**

(72) Inventor : **Savas, Stephen E.**
**35358 Newcastle Court**
**Newark, California 94560 (US)**

(74) Representative : **Kahler, Kurt, Dipl.-Ing.**
**Patentanwälte Kahler, Käck & Fiener**
**Maximilianstrasse 57**
**Postfach 12 49**
**D-87712 Mindelheim (DE)**

## Description

### Field of the Invention

The present invention relates to electrostatic clamps and, in particular, to the use of electrostatic clamps to hold workpieces such as semiconductor wafers on supports such as pedestals in plasma processing reactors.

### Background of the Invention

The available techniques for holding wafers on pedestals or other supports in semiconductor wafer plasma processing reactors include mechanical clamping, vacuum clamping and electrostatic clamping.

Vacuum clamps are ineffective at the relatively high vacuum levels useful in present and future reactors.

Mechanical clamping involves clamping the wafer against the support using a peripheral ring or fingers. While mechanical clamps are effective under vacuum conditions, they have a number of shortcomings. For example, the movement of mechanical tooling can generate particulates, as can the contact between the mechanical clamps and the wafer surface. Furthermore, clamps shadow underlying regions of the wafer and may break or otherwise damage the wafer.

Also, the characteristics of the plasma are altered in the vicinity of clamps, thereby inducing process non-uniformity across the wafer and, in particular, at the edge of the wafer relative to the central portion. For example, etch rates may be reduced at the clamped edge of the wafer. This problem is exacerbated by the industry-wide practice of forming rectangular chips on circular wafers. To reduce wasted space, the chips are placed over the whole surface, including the areas very close to the edge of the wafer, that is, in the region affected by the plasma non-uniformities.

Electrostatic wafer clamps inherently do not suffer from the above-described problems. A typical electrostatic clamping design uses a pair of electrodes embedded in a dielectric matrix and biased oppositely and equally with respect to ground, for example, at ± 300 volts.

A representative multiple electrode pair type of electrostatic clamp is disclosed in U.S. Patent 4,184,188. That clamp includes a blade; a multiplicity of interleaved, positive and negative, paired electrodes which are arranged on the blade's surface; and a dielectric layer formed over the electrodes. When an electrically conducting wafer is placed over the electrodes and sufficient electrical potential is applied to the electrodes, negative charges in the wafer flow to the region of the wafer over the positively-charged electrode leaving positive charges on the wafer surface just over the negatively-charged electrodes.

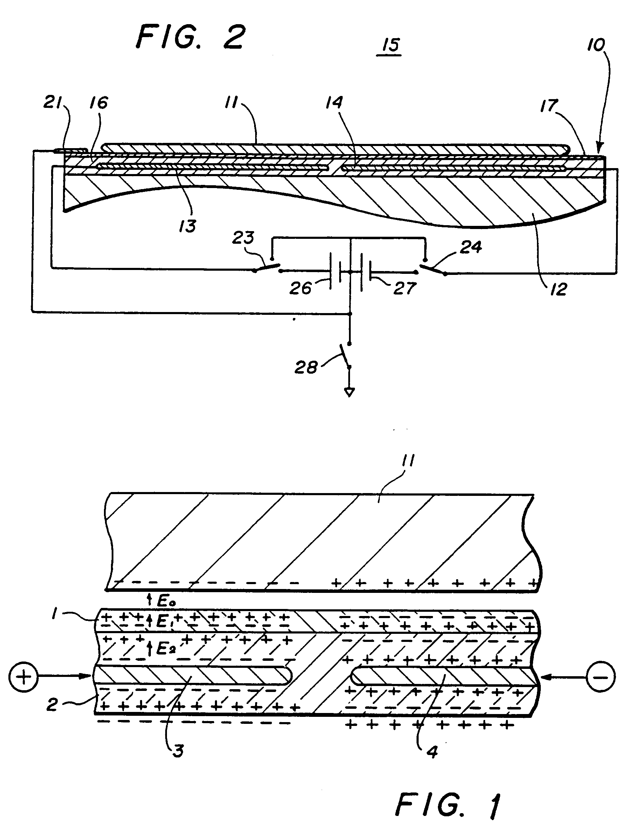

The electrostatic fields and polarized charges associated with such clamps are shown in FIG. 1, which depicts a clamping structure comprising dielectric layers 1 and 2, positive and negative electrodes 3 and 4 embedded in layer 2, and wafer 11. The dielectric layers 1 and 2 provide electrical insulation between the conducting structures 3 and 4 (which are externally biased) and the wafer 11, and also increase the electric field, $E_o$, in the vacuum gap between wafer 11 and the upper dielectric layer 1. The clamping pressure, $P_{clamp}$, can be calculated from the thickness of the dielectric layers, their dielectric constants, and the voltage, $V_{clamp}$, applied to the clamp electrode(s). For this design, we assume that the clamp electrodes 3 and 4 are biased equally positive and negative with respect to the wafer surface's self-bias, so there is no net charging of the wafer when the clamp voltage is applied.

Referring further to FIG. 1, in general $E_i = E_1, E_2, ... E_n$ are the electric field strengths inside the respective dielectric layers i = 1,2, ... n, which have dielectric constants $k_i = k_1, k_2, ... k_n$ and thicknesses $t = t_1, t_2, ... t_n$. The value of $E_n$ is $E_o/k_n$, where $E_o$ is the electric field in a microscopically thin vacuum gap between the bottom of the wafer 11 and the top surface of the upper dielectric layer 1. It can be shown that:

$$\{t_1/k_1 + t_2/k_2 + ... + t_n/k_n\} E_o = V_{clamp}, \quad (1)$$

where $V_{clamp}$ is the electrical potential for either clamp electrode relative to the wafer.

Solving (1) for $E_o$ gives:

$$E_o = V_{clamp}/ \{t_1/k_1, + t_2/k_2 + ... + t_n/k_n\}. \quad (2)$$

The clamp pressure, $P_{clamp}$, is found using:

$$P_{clamp} = \sigma E_o, \quad (3)$$

where $\sigma$ is the surface charge density (coul/m² in mks units) on the bottom of the wafer 11, or equally, that on the upper surface of the conductors 3 and 4 in the clamp. The charge density is found by using Gauss' law, which yields:

$$E_o = \sigma/\varepsilon_o, \quad (4)$$

where $\varepsilon_o$ is the permittivity of free space, 8.8 x 10EXP-12 in mks units. For the illustrated case of a two layer dielectric with negligible vacuum gap we find by substituting $\sigma$ from (4) into (3) and $E_o^2$ from (2) into (3):

$$P_{clamp} = \varepsilon_o E_o^2 = \varepsilon_o \left\{ \frac{V_{clamp}}{t_1/k_1 + t_2/k_2} \right\}^2, \quad (5)$$

where $t_1 = x_1-x_o$, the thickness of the top layer 1 of dielectric and $t_2 = x_2-x_1$, for the second layer 2. The units of $P_{clamp}$ are newtons/$_m^2$ which are about 1.42 x $10^{-4}$ psi for each N/m².

If, for example, $t_1 = 0.03$ mm (30µ) for an upper layer of $Al_2O_3$, for which $k_1 = 9$ and $t_2 = 0.1$ mm (100µ) for lower layer 2 of $TiO_2$ which has $k_2=60$, then from (5): $P_{clamp} = 3.5 V^2_{clamp}$ (N/m²) $\approx 5.10^{-4} V^2_{clamp}$ (psi).

Thus, a clamping voltage of 100 volts would produce about 5 psi clamping pressure ($5.10^{-4} \times (10^2)^2$). If, due to a dust particle or surface irregularity there were to be a $1\mu$ vacuum gap added, it would reduce the pressure by about thirty percent (30%) in the region where the gap is, as can be easily shown from equation 5.

As shown above, in both the single and the multiple pair clamps, the resulting clamping pressure, $P_{clamp}$, is directly proportional to the electrostatic forces acting upon the wafer. Specifically, this force is directly proportional to the square of the applied voltage, $V_{clamp}$, and the square of the dielectric constant, $k_i$, and inversely proportional to the square of the dielectric layer thickness, $t_i$. Quite apparently, the relationship evidenced in equation (5) provides motivation for using a thin, large k dielectric, if possible. This pressure, $P_{clamp}$, is applied without in-vacuo moving mechanical parts and without mechanically contacting the workpiece or disturbance of the plasma. However, such electrostatic clamping techniques have a number of important design and operational requirements, and potential shortcomings, which are summarized below.

## 1. Uniform Clamping Forces

First, a sufficient, uniform clamping pressure must be sustainable so that the wafer or workpiece is securely held flat, to provide uniform power deposition, and so that heat transfer is uniform to the underlying chuck or pedestal. During plasma operation, however, the plasma electrically charges and thereby biases the wafer potential negatively, with the result that the potential difference and the associated clamping force between the negative electrode and the wafer are decreased, while the potential difference and clamping force between the positive electrode and the wafer are increased. The obvious result is uneven clamping force, non-uniform inadequate thermal conduction between the wafer and the pedestal (conduction is the primary mode of wafer cooling in a vacuum) and, thus, non-uniform inadequate cooling and non-uniform processing.

## 2. Voltage Drop Across High Resistivity Dielectrics

Secondly, the clamp structure should not have a substantial impedance to rf power penetration because the associated voltage drop increases power dissipated in the impedance match network and the voltage required to sustain an rf discharge in which the wafer-holding electrode is powered. Typically, as described above, wafers are supported on one of the rf electrodes on which the electrostatic clamp is formed or attached. RF current (i. e., displacement current) must be conducted through the clamp dielectric to the plasma in order to complete the rf circuit. The dielectric must also have a relatively high dielectric strength in order to withstand the high electric fields associated with the clamping voltage of several hundred volts and the power surges and transients which might occur, e . g., where the clamping circuit is switched on. It can be shown that the high rf impedance of thick dielectrics typically used in electrostatic clamping causes a substantial voltage drop. For example, for $Al_2O_3$ or similar dielectric about 8-10 millimeters thick, having a dielectric constant, k, of about 10, and $\varepsilon_0$ about $8.8 \times 10^{-12}$, the resulting rf voltage drop at 13.56 MHz can exceed 100 volts. In short, the use of a relatively thick dielectric results in a relatively large voltage drop associated with the rf current through the dielectric, and requires the application of a commensurately higher voltage, and thus higher current through the stray capacitance of the powered electrode, to sustain the discharge at a given power level.

## 3. Release Time

Third, it is necessary that the surface charges responsible for the clamping force dissipate quickly, releasing the wafer from the clamp promptly after the clamping voltage is removed. However, electrostatic clamps or chucks often use a dielectric having a high resistivity, of the order of or greater than $10^{15}$ ohm centimeters. As a result, after the applied clamping voltage is turned off, perhaps thirty seconds elapse before the surface charge dissipates sufficiently that the wafer is released from the clamp. This delay reduces reactor throughput.

## Summary of the Invention

### Objects

As implied by the above discussion, it is a primary objective of the present invention to provide an electrostatic clamp which is useful in a plasma processing environment, and which clamps the workpiece to the associated support with a force which is uniform in time and space.

It is a second, related objective of the present invention to provide a clamp structure as described above in which the impedance to rf power penetration is substantially reduced from the levels seen in prior designs such as those discussed above.

It is another, related objective of the invention to provide an electrostatic clamp having a dielectric with reduced resistivity, so that the surface charges responsible for the clamping force dissipate quickly after the clamping voltage is removed, allowing quick release of the wafer from the clamp.

It is yet another objective of the present invention to provide an electrostatic clamp structure which has a multiple layered dielectric to provide both resistance to electrical breakdown and to avoid exposing potentially contaminating materials to the plasma that could be a source of damage to the devices or circuits when the clamped workpiece is a semiconductor wafer.

## Summary

In one aspect, the invention which accomplishes the above and other related objectives is embodied in an electrostatic workpiece clamp and its related method of use. The clamp is formed on a workpiece support in a plasma processing environment, which comprises at least a pair of electrodes embedded in a dielectric material mounted or otherwise attached to the support; means for supplying positive and negative voltage to the respective electrodes; and characterized in that an electrode is exposed to the plasma and connected to the voltage supply means for applying the plasma voltage as the reference voltage to the voltage supply means. Reflecting the fact that thicker dielectrics require higher clamping voltages and cause larger rf drops for a fixed rf current flow through the electrostatic chuck, preferably, the dielectric thickness is substantially less than 1 millimeter, causing an rf voltage drop across the clamp of substantially less than 100 volts. Typically, a thin dielectric also simplifies the task of cooling the wafer because heat can be conducted more readily through it once the heat is conducted from the bottom surface of the wafer to the top surface of the dielectric.

In another preferred aspect, the dielectric has a resistivity less than about $10^{12}$ ohm centimeter, for enhancing charge dissipation upon removal of the clamping voltage and thereby providing a wafer release time substantially less than 30 seconds.

In another specific aspect, my present invention is embodied in an electrostatic workpiece clamp formed on a pedestal within a plasma processing chamber, comprising: at least one pair of generally flat semi-circular electrodes or conductors embedded in a dielectric and mounted in thermally conductive contact on the pedestal; a pair of series-connected power supplies for applying positive and negative voltages to the respective electrodes of the pair; and a reference electrode positioned within the plasma and exposed to the same plasma voltage as the wafer. The reference electrode is adapted for electrical connection between the two power supplies, to apply the plasma voltage level experienced by the wafer as a reference voltage to the positive and negative power supplies, thus biasing the clamping electrodes equally and oppositely.

In still another aspect, the invention relates to a method of electrostatically clamping a workpiece on an electrode in a plasma processing environment, by placing the workpiece on an electrostatic clamp having at least a pair of positive and negative conductors, and generating a plasma in the vicinity of the workpiece while applying voltages which are positive and negative (relative to the workpiece) to the respective conductors, for clamping the workpiece thereto and applying a plasma self-bias voltage proximate the workpiece as a common reference to the positive and negative voltages.

## Brief Description of the Drawings

The above and other aspects of my invention are disclosed in the enclosed drawings in which:
FIG. 1 schematically depicts the electric fields associated with a two-dielectric-layer electrostatic clamp;
FIG. 2 schematically depicts the structure of the electrostatic clamp of the invention;
FIGS. 3 and 4 are, respectively, a plan view and a vertical section view taken in the direction 4-4 in FIG. 3, showing a preferred non-cooled embodiment of the electrostatic clamp of the invention; and
FIGS. 5 and 6 are, respectively, a plan view and a vertical cross-sectional view taken along the line 6-6 in FIG. 5, showing a preferred gas-cooled embodiment of the electrostatic clamp of the invention.

## Detailed Description of the Preferred Embodiment(s)

According to one aspect of the invention, differences in the clamping forces exerted by the positive and negative electrodes of an electrostatic clamp are eliminated by the use of a circuit which incorporates a reference electrode on that portion of the pedestal or chuck that is exposed to the plasma. The reference electrode biases the positive and negative electrodes equally with respect to the wafer.

The biasing circuit, reference electrode and other features of the invention are depicted in FIG. 2, which shows a flat workpiece such as a semiconductor wafer 11 supported on an electrostatic clamp 10 formed on an rf powered metal electrode pedestal 12 situated in a low pressure plasma reactor chamber 15. The clamp 10 comprises a pair of generally semi-circular conductive metal electrodes 13 and 14 which are embedded in or coated with a high k (dielectric constant) electrically insulating material 16 and, optionally, a thin protective dielectric surface coating 17. The surface coating 17 preferably is formed of a material such as polyimid or Teflon™ which is very clean and does not introduce particulates into the process chamber environment.

Reference electrode 21 is formed of a conductor such as silicon or metal on a portion of the clamp 10 which is exposed to the chamber's plasma processing environment 15. As shown in FIG. 2, preferably the electrode 21 is positioned in proximity to the wafer 11.

A pair of series-connected batteries or other DC power supplies 26,27 and switches 23,24 selectively apply the positive and negative voltages from the power supplies to the respective positive and negative clamping electrodes 13 and 14. Appropriate resistors, capacitors and inductors may be included to prevent rf voltage from the electrodes getting into the biasing circuitry and too rapid changes in electrode voltages. The reference electrode 21 is connected between the power supplies. By opening a switch 28 to disconnect the power supplies from system ground, the reference electrode applies the bias potential experienced by the surface of the pedestal and by the wafer as the reference voltage to the DC power supplies 26 and 27 ensuring that the positive and negative potentials applied to the electrodes have the same magnitude (e.g., 300 volts) relative to the outer surface of the clamp and the wafer.

In short, the reference electrode 21 maintains the same magnitude potential difference between the positive electrode and the wafer on the one hand and between the negative electrode and the wafer on the other hand, despite the existence and fluctuation of the plasma self-biasing voltage. As a consequence, the reference electrode ensures that the positive and negative electrodes exert equal clamping force. The resultant uniform clamping force across the face of the wafer tends to flatten the wafer 11 against the pedestal 12, despite deviations from planarity on the part of wafer, and enables uniform power deposition. Also, the uniform clamping force enables the uniform thermal conduction between the wafer and pedestal which is so essential to adequate, uniform cooling of the wafer in the absence of gas cooling and, thus, uniform process characteristics.

Preferably, the dielectric material has a combination of (1) high dielectric strength to permit the use of a dielectric coating 16 which is very thin relative to the layers of dielectric typically used for electrostatic clamps and (2) high dielectric constant, to permit the use of low clamping voltages without compromising clamping pressure. (See Equation (5).)

One suitable dielectric material is the hard anodized aluminum coating material available under the trade name Magnaplate HCR™ from General Magnaplate. Magnaplate HCR™ anodized aluminum has a dielectric constant, k, of about 9. The use of such material permits the dielectric coating to be reduced to much less than 1 mm thickness, e.g., to be reduced to 0.05 mm. This reduces the rf voltage drop through the clamp from the underlying electrode from 100 volts to less than 1 volt and, thus, provides low impedance transmission of rf power through the clamp. The substantially reduced voltage drop results in a commensurate reduction in the voltage which must be supplied to the powered electrode in order to sustain the plasma discharge which reduces power loses in the impedance match network. The thin, high k dielectric also permits low d.c. voltages to be used for the offsets of the clamping electrodes while maintaining high clamping pressure (>1 psi).

Another suitable dielectric material is alumina porcelain such as Coors Porcelain AD94, which has a dielectric constant of approximately 8.9, very low dielectric dissipation ($10^{-3}$) and reasonable thermal conductivity (approximately 0.04 cal/cm$^2$/cm/sec/°C). The dielectric strength of this material is sufficiently high (approximately 600 volts/mil) that it can withstand many times the voltage experienced by the clamp. That is, it easily withstands transients and power surges.

Also, the thickness of the additional thin dielectric coating 17 can be tailored to provide a compliant, heat conductive heat transfer layer between wafer and E-chuck. With such a dielectric thickness, the clamp force is not significantly reduced by small gaps or particles. Thus, for a thickness of 0.15 millimeter (0.006 inch) of aluminum porcelain, a one micron gap between the wafer and the clamp caused by particulates or non-perfect planarity in the wafer results in only a six percent decrease in clamping pressure locally.

In addition, it was determined that the described anodized aluminum and porcelain ceramic materials can be doped with a few weight percent of impurities such as copper to reduce the usual resistivity from $10^{15}$-$10^{16}$ ohm centimeter to about $10^{12}$ ohm centimeter or less. This greatly accelerates surface charge dissipation and reduces the release time to a few seconds. Preferably, the doping is done by ion implantation of the formed dielectric coating(s) 16 or during formation of the coating(s), as by introducing an impurity during sputter coating of the dielectric.

Furthermore, the low dielectric resistivity permits a very low voltage to be maintained between the exposed clamp surfaces and the clamp electrodes when a wafer clamping voltage is not being applied or when a plasma cleaning process is being used, to minimize or prevent particle accumulation on the surface of the clamp.

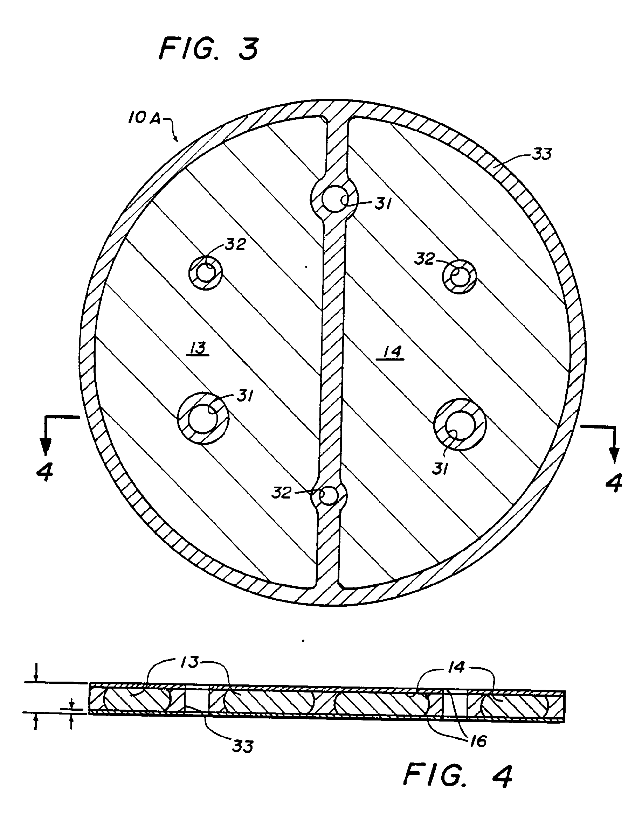

FIGS. 3 and 4 depict a non-cooled embodiment 10A of the schematized version 10 of the electrostatic clamp shown in FIG. 1. The illustrated semi-circular electrodes 13 and 14 are conductors such as aluminum. In general, the opposite polarity electrodes may be of essentially any complementary configuration (such as interdigitated fingers) which have substantially equal areas and together occupy most of the clamp surface area. A coating of material such as the above-mentioned preferred Magnaplate HCR™ high k dielectric may be formed on the top and bottom surfaces of the clamp electrodes by anodization. (Alternatively, the dielectric can be deposited by sputter deposition.) The anodized electrodes may have holes formed therein, such as holes 31 for wafer support pins and holes 32 for bolting to the pedestal 12. Leads (not shown) are attached to the anodized electrodes at the periphery of the electrodes, and the electrodes may be placed in a frame 33 made of Ardel™ insulator (or other suitable insulator) such that the electrodes are flush with the top and bottom surfaces of the frame. As mentioned, the dielectric may be doped with an impurity such as copper, nickel, chromium, silicon, nitrogen, etc., either during the formation of the anodization or afterward by ion implantation, to reduce the electrical resistivity to about $10^{12}$ ohm centimeter or less. The preferred range of thicknesses using the Magnaplate HCR™ dielectric is 0.025 - 0.05 millimeters.

Forming the clamp as described above using the Magnaplate HCR™ dielectric material of thickness 0.025 mm on the top and bottom surfaces and forming a reference electrode of silicon or SiC on the outer/upper surface of the exposed surface of the electrode, provides a clamping force of $\geqq$ 1 psi for applied electrode clamping voltages < 100 volts and provides an rf voltage drop across the electrostatic clamp of < 1 volt. In addition, the release time is 1 - 3 sec.

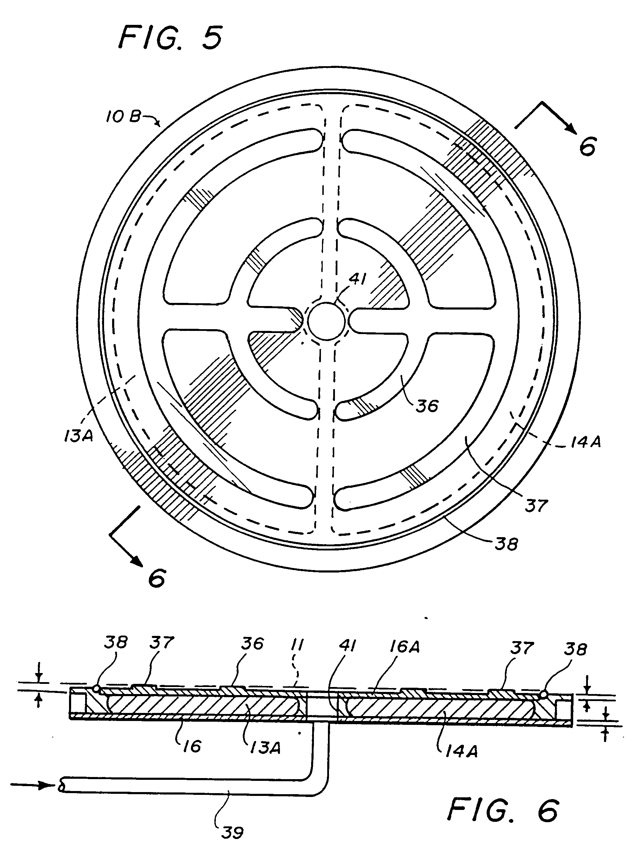

FIGS. 5 and 6 depict an alternative version 10B of the electrostatic clamp, one which is designed for gas cooling. In this illustrated case, the top dielectric layer 16A is formed with a plurality of annular, generally concentric raised areas 36 and 37 for the purpose of forming gas reservoirs behind the wafer. A circumferential gasket 38 provides a gas seal between the clamp and the wafer. (The seal need not be gas-impervious; in fact, it may be desirable to use process gas as the cooling gas and to bleed the process gas peripherally out from the wafer into the process chamber 15.) As illustrated schematically, process gas may be applied via suitable conduit(s) 39 in the pedestal 12 and the center hole 41 in the clamp to the interface between the wafer 11 and the clamp 10.

## Claims

1. An electrostatic workpiece clamp (10) suitable for a plasma processing environment (15), comprising: at least a pair of electrodes (13, 14; 13A, 14A) embedded in a dielectric material (16); means (23, 24, 26, 27) for supplying positive and negative voltage to the respective electrodes (13, 14); and characterized in that an electrode (21) is exposed to the plasma environment (15) and connected to the voltage supply means (23, 24, 26, 27) for applying the plasma voltage as the reference voltage to the voltage supply means.

2. The electrostatic clamp of claim 1, wherein the dielectric (16) thickness is substantially less than one millimeter for providing a low rf voltage drop across the clamp substantially less than 100 volts.

3. The electrostatic clamp of claim 1 or 2, wherein the dielectric (16) has a resistivity of about $10^{10}$ - $10^{12}$ ohm centimeter for providing a wafer release time substantially less than 30 seconds.

4. The electrostatic clamp of claim 1, 2, or 3, wherein the dielectric (16) has multiple layers to reduce contamination and aid heat transfer.

5. The electrostatic clamp of any preceding claim, wherein said electrostatic clamp (10) is formed on a pedestal (12) within a plasma-processing chamber (15) for holding said flat workpiece, such as a semiconductor wafer (11), on said pedestal, said electrodes are generally flat complementary-shaped electrodes or conductors (13, 14; 13A, 14A) embedded in said dielectric (16) and mounted in thermally conductive contact on the pedestal (12), said supply means is a pair of series-connected power supplies (26, 27) for applying positive and negative voltages to the respective electrodes (13, 14; 13A, 14A) of said pair, and a reference electrode (21) is positioned within the plasma at the same self-bias voltage as the wafer (11), the reference electrode (21) being adapted for electrical connection (23, 24) between the two power supplies (26, 27) for supplying the self-bias voltage on the wafer (11) as a reference voltage to the positive and negative power supplies (26, 27).

6. The electrostatic clamp of claim 5, wherein the two power supplies are batteries.

7. The electrostatic clamp of any preceding claim, comprising gas cooling means (39, 41).

8. The electrostatic clamp of claim 7, wherein a top layer (16A) of said dielectric (16) is formed with a plurality of annular, generally concentrically raised areas (36, 37) for forming cooling gas reservoirs behind said wafer (11).

9. A method of electrostatically clamping a workpiece in a plasma processing environment (15) comprising: providing an electrostatic clamp (10) having at least a pair of positive and negative conductors affixed to a support electrode (13, 14; 13A, 14A); and generating a plasma in the vicinity of the workpiece while applying relatively positive and negative voltages to the respective conductors for clamping the workpiece thereto and applying a plasma self-bias voltage proximate the workpiece as a common reference to the positive and negative voltages.

10. The method of claim 9, further comprising the step of cooling said clamp (10).

## Patentansprüche

1. Eine elektrostatische Werkstück-Klemmvorrichtung (10), die für eine Plasmaarbeitsumgebung (15) geeignet ist, mit: zumindest einem Paar Elektroden (13, 14; 13A, 14A), die in einem dielektrischen Material (16) eingebettet sind; und einer Einrichtung (23, 24, 26, 27) zum Zuführen einer positiven und einer negativen Spannung zu den entsprechenden Elektroden (13, 14); dadurch **gekennzeichnet** daß eine Elektrode (21) der Plasmaumgebung (15) ausgesetzt und mit der Spannungszuführeinrichtung (23, 24, 26, 27) zum Anlegen der Plasmaspannung als Bezugsspannung an die Spannungszuführeinrichtung verbunden ist.

2. Die elektrostatische Klemmvorrichtung nach Anspruch 1, wobei die Dicke des Dielektrikums (16) zum Vorsehen eines geringen HF-Spannungsabfalls an der Klemmvorrichtung, der im wesentlichen geringer als 100 Volt ist, im wesentlichen geringer als ein Millimeter ist.

3. Die elektrostatische Klemmvorrichtung nach Anspruch 1 oder 2, wobei das Dielektrikum (16) einen spezifischen Widerstand von etwa $10^{10}$ - $10^{12}$ Ohm·Zentimeter zum Vorsehen einer Halbleiterscheiben-Freigabezeit von im wesentlichen weniger als 30 Sekunden aufweist.

4. Die elektrostatische Klemmvorrichtung nach Anspruch 1, 2, oder 3, wobei das Dielektrikum (16) eine Vielzahl von Schichten zum Verringern einer Verschmutzung und zum Unterstützen der Wärmeübertragung aufweist.

5. Die elektrostatische Klemmvorrichtung nach irgendeinem vorhergehenden Anspruch, wobei die elektrostatische Klemmvorrichtung (10) auf einem Sockel (12) innerhalb einer Plasmaarbeitskammer (15) zum Halten des flachen Werkstücks, beispielsweise einer Halbleiterscheibe (11), auf dem Sockel ausgebildet ist, wobei die Elektroden allgemein flach komplementär geformte Elektroden oder Leiter (13, 14; 13A, 14A) sind, die in dem Dielektrikum (16) eingebettet und in wärmeleitfähigem Kontakt an dem Sockel (12) befestigt sind, die Zuführeinrichtung ein Paar in Reihe verbundener Leistungszuführeinrichtungen (26, 27) zum Anlegen einer positiven und einer negativen Spannung an die entsprechenden Elektroden (13, 14; 13A, 14A) des Elektrodenpaars ist, und eine Bezugselektrode (21) innerhalb des Plasmas mit der gleichen Selbst-Vorspannung wie die Halbleiterscheibe (11) angeordnet ist, wobei die Bezugselektrode (21) für eine elektrische Verbindung (23, 24) zwischen die beiden Leistungszuführeinrichtungen (26, 27) zum Anlegen der Selbst-Vorspannung an der Halbleiterscheibe (11) als Bezugsspannung an die positive und die negative Leistungszuführeinrichtung (26, 27) ausgelegt ist.

6. Die elektrostatische Klemmvorrichtung nach Anspruch 5, wobei die beiden Leistungszuführeinrichtungen Batterien sind.

7. Die elektrostatische Klemmvorrichtung nach irgendeinem vorhergehenden Anspruch, aufweisend eine Gas-Kühleinrichtung (39, 41).

8. Die elektrostatische Klemmvorrichtung nach Anspruch 7, wobei eine oberste Schicht (16A) des Dielektrikums (16) mit einer Vielzahl von ringförmigen, sich im allgemeinen konzentrisch erhebenden Bereichen (36, 37) zum Ausbilden von Kühlgasreservoirs hinter der Halbleiterscheibe (11) ausgebildet ist.

9. Ein Verfahren zum elektrostatischen Festklemmen eines Werkstücks in einer Plasmaarbeitsumgebung (15), das aufweist: das Vorsehen einer elektrostatischen Klemmvorrichtung (10), die zumindest ein Paar, bestehend aus einem positiven und einem negativen Leiter aufweist, die an einer Trägerelektrode (13, 14; 13A, 14A) befestigt sind; und das Erzeugen eines Plasmas in der Nähe des Werkstücks während des Anlegens einer relativ positiven bzw. negativen Spannung an die entsprechenden Leiter, um das Werkstück daran festzuklemmen, und des Zuführens einer Plasma-Selbstvorspannung in der Nähe des Werkstücks als gemeinsamer Bezug zur positiven und zur negativen Spannung.

10. Das Verfahren nach Anspruch 9, ferner aufweisend den Schritt des Kühlens der Klemmvorrichtung (10).

## Revendications

1. Dispositif de serrage électrostatique de pièces (10) adapté à un environnement de traitement par un plasma (15) et comprenant au moins une paire d'électrodes (13, 14; 13A, 14A) noyées dans un matériau diélectrique (16) ; et un moyen (23, 24, 26, 27) pour appliquer des tensions positive et négative aux électrodes respectives (13, 14), caractérisé par le fait qu'une électrode (21) est exposée à l'environnement du traitement par le plasma (15), et qu'elle est reliée au moyen (23, 24, 26, 27) d'application d'une tension pour appliquer à ce moyen d'application d'une tension la tension du plasma qui sert de tension de référence.

2. Dispositif de serrage électrostatique selon la revendication 1, dans lequel l'épaisseur du diélectrique (16) est sensiblement inférieure à 1 mm, afin d'obtenir aux bornes du dispositif de serrage une chute de tension haute fréquence qui soit faible et sensiblement inférieure à 100 volts.

3. Dispositif de serrage électrostatique selon la revendication 1 ou 2, dans lequel le diélectrique (16) présente une résistivité de $10^{10}$ à $10^{12}$ ohm-centimètre environ, afin d'obtenir une durée de desserrage de la pastille qui soit sensiblement inférieure à 30 secondes.

4. Dispositif de serrage électrostatique selon la revendication 1, 2 ou 3, dans lequel le diélectrique (16) comprend des couches multiples, afin de réduire la contamination et de concourir au transfert de chaleur.

5. Dispositif de serrage électrostatique selon l'une quelconque des revendications précédentes, dans lequel ledit dispositif de serrage électrostatique (10) est formé sur un socle (12) à l'intérieur d'une chambre (15) de traitement par un plasma pour maintenir sur ledit socle ladite pièce plate, comme une pastille semi-conductrice (11), lesdites électrodes sont des électrodes ou des conducteurs (13, 14 ; 13A, 14A) de formes complémentaires qui sont plats d'une façon générale, qui sont noyés dans ledit diélectrique (16) et qui sont montés sur le socle (12) en présentant un contact conducteur de la chaleur, ledit moyen d'application d'une tension est une paire d'alimentations en énergie (26, 27) montées en série pour appliquer des tensions positive et négative aux électrodes respectives (13, 14 ; 13A, 14A) de ladite paire, et une électrode de référence (21) est positionnée à l'intérieur du plasma à la même tension de polarisation automatique que la pastille (11), l'électrode de référence (21) étant susceptible d'être reliée électriquement (23, 24) à un point situé entre les deux alimentations en énergie (26, 27) pour fournir à la pastille (11) la tension de polarisation automatique qui sert de tension de référence aux alimentations en énergie positive et négative (26, 27).

6. Dispositif de serrage électrostatique selon la revendication 5, dans lequel les deux alimentations en énergie sont des batteries.

7. Dispositif de serrage électrostatique selon l'une quelconque des revendications précédentes, comprenant un moyen (39, 41) de refroidissement par un gaz.

8. Dispositif de serrage électrostatique selon la revendication 7, dans lequel une couche supérieure (16A) dudit diélectrique (16) présente une pluralité de zones annulaires (36, 37) en saillie qui sont concentriques d'une façon générale et qui forment des réservoirs de gaz de refroidissement derrière ladite pastille (11).

9. Procédé de serrage électrostatique d'une pièce dans un environnement de traitement par un plasma (15), comprenant le fait que l'on prévoit un dispositif de serrage électrostatique (10) comprenant au moins une paire de conducteurs positif et négatif fixés à une électrode formant support (13, 14 ; 13A, 14A) ; et que l'on engendre un plasma au voisinage de la pièce en appliquant des tensions relatives positive et négative aux conducteurs respectifs, afin de serrer la pièce et d'appliquer une tension de polarisation automatique du plasma au voisinage de la pièce, tension qui sert de référence commune aux tensions positive et négative.

10. Procédé selon la revendication 9, comprenant en outre l'étape de refroidissement dudit dispositif de serrage (10).

# FIG. 2

# FIG. 1

FIG. 3

10 A

33

31

32

32

13

14

31

31

31

32

4

4

13

14

33

16

FIG. 4

FIG. 5

10 B

6

41

36

13A

14A

37

38

6

38 37 36 11 41 16A 37 38

16 13A 14A

39

FIG. 6